Europäisches Patentamt

European Patent Office

Office européen des brevets

(11) Veröffentlichungsnummer: **0 243 835 B1**

## EUROPÄISCHE PATENTSCHRIFT

(45) Veröffentlichungstag der Patentschrift: 29.05.91

(21) Anmeldenummer: 87105767.5

(22) Anmeldetag: 18.04.87

(51) Int. Cl.⁵: **G01R 19/175**, G01R 19/00, H03K 5/153

(54) **Messanordnung in Systemen mit digitalen Untergruppen zur Erfassung von Spannung, Strom und Phasenwinkel.**

(30) Priorität: 29.04.86 DE 3614419

(43) Veröffentlichungstag der Anmeldung:
04.11.87 Patentblatt 87/45

(45) Bekanntmachung des Hinweises auf die Patenterteilung:
29.05.91 Patentblatt 91/22

(84) Benannte Vertragsstaaten:
AT DE FR GB SE

(56) Entgegenhaltungen:
US-A- 4 459 546

POLYTECHNISCH TIJDSCHRIFT/ELEKTROTECHNIEK ELEKTRO-NICA, Band 39, Nr. 1, Januar 1983, Seiten 13-17, Rijswijk, NL; W. TEBRA: "Standaarden en kalibratie-apparatuur"

IBM TECHNICAL DISCLOSURE BULLETIN, Band 18, Nr. 1, 1975, Seite 144, New York, US; H. BRAQUET et al.: "Zero-crossing detector"

ELEKTRONIK, Band 31, Nr. 14, Juli 1982, Seite

61, München, DE; U. KREBS: "Nullspannungsdetektor mit NE 555"

ELEKTOR, Band 11, Nr. 7/8, Juli-August 1985, Seite 7-69, Canterbury, GB; "Simple zero crossing detector"

(73) Patentinhaber: MASCHINENFABRIK REINHAU-SEN GMBH
Postfach 120360
W-8400 Regensburg(DE)

(72) Erfinder: Kugler, Kurt, Dipl.-Ing. (FH)
Kellerweg 12
W-8411 Hainsacker(DE)

## Beschreibung

Die Erfindung bezieht sich auf eine Meßanordnung in Systemen mit digitalen Untergruppen zum Messen von Wechselspannung, Wechselstrom und Phasenwinkel mittels jeweils eines Spannungswandlers und Stromwandlers, die jeweils sekundärseitig mit einem Multiplexer in Verbindung stehen.

Eine derartige Meßanordnung ist aus US-A-4 459 546 bekannt.

Eine Schwierigkeit bei derartigen Meßanordnungen liegt in der Bestimmung des Phasenwinkels, also in der exakten Erfassung des Zeitpunktes des Nulldurchganges von Strom und Spannung, insbesondere dann, wenn große Meßsignalbereiche verarbeitet werden sollen. Diese Schwierigkeit begründet sich darin, daß ein gegen Null gehender Wert praktisch nicht meßbar ist.

Aufgabe der Erfindung ist es deshalb, eine Meßanordnung anzugeben, bei der diese Schwierigkeit vermieden wird. Diese Aufgabe wird bei der eingangs genannten Meßanordnung dadurch gelöst, daß der Ausgang des Multiplexers mit einem Analog-Digital-Wandler verbunden ist, und daß jeweils ein Pol der Sekundärseiten von Spannungs- und Stromwandler am Potential derjenigen Referenzspannung lieget, die dem Multiplexer als Bezugsgröße für die zu messenden Spannungs- und Stromwerte aufgeschaltet ist.

Der mit der Erfindung erzielte Vorteil liegt vor allem darin, daß es hiermit möglich ist, den Zeitpunkt des Nulldurchganges eines Meßsignals bis hin zu kleinsten Meßsignalen exakt zu erfassen. Wird z.B. ein 10-Bit AD-Wandler verwendet, können Meßsignale bis zu 0,2 % des Nennwertes noch verarbeitet werden. Weiter ist von Vorteil, daß Temperaturgänge des Analog-Digital-Wandlers und der Referenzspannung keinen Einfluß auf die Meßgenauigkeit haben.

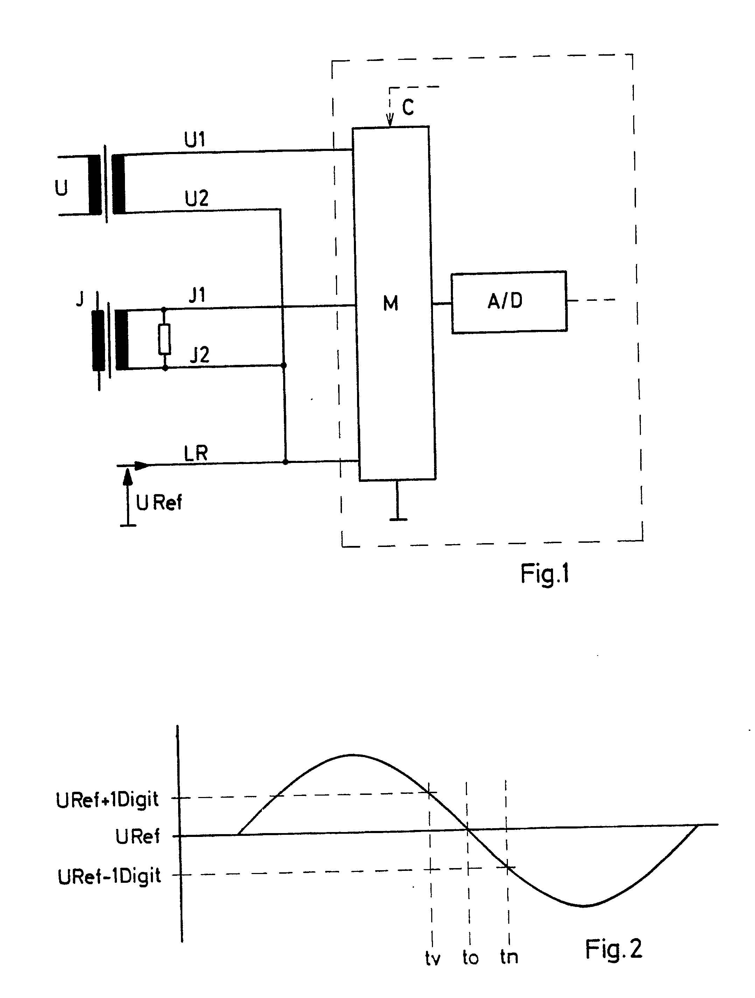

Die Zeichnung zeigt in Figur 1 beispielhaft eine Meßanordnung als Schaltbild. Wie ersichtlich, sind ein Spannungswandler (U) und ein Stromwandler (J) mit je einem Pol (U1 bzw.J1) an einem Multiplexer (M) angeschlossen. Jeweils der andere Pol (U2 bzw. J2) von Spannungswandler und Stromwandler liegen an einer Leitung (LR), die mit einer Referenzspannung (URef) beaufschlagt ist und die am Multiplexer (M) angeschlossen als Bezugsgröße für die zu messenden Spannungs- und Stromwerte dient. Der Multiplexer (M) ist mit dem Analog-Digital-Wandler (A/D) verbunden. Die Ansteuerung (C) des Digitalsystems erfolgt auf übliche Weise.

Figur 2 zeigt, wie der Zeitpunkt des Nulldurchganges zweckmäßiger Weise erfaßt wird. Meßtechnisch erfaßt werden hierbei der Zeitpunkt (Tv) bei einem Meßwert URef + 1 Digit und der Zeitpunkt (tn) bei einem Meßwert URef - 1 Digit. Der Nulldurchgang läßt sich berechnen nach

$$\frac{t_0}{T_0} = \frac{t\pi v + t\pi n}{2}.$$

## Ansprüche

1. Meßanordnung in Systemen mit digitalen Untergruppen zum Messen von Wechselspannung, Wechselstrom und Phasenwinkel mittels jeweils eines Spannungswandlers (U) und Stromwandlers (J), die jeweils sekundärseitig (U1 und J1) mit einem Multiplexer in Verbindung stehen, **dadurch gekennzeichnet**, daß der Ausgang des Multiplexers mit einem Analog-Digital-Wandler verbunden ist, und daß jeweils ein Pol (U2 und J2) der Sekundärseiten von Spannungs- und Stromwandler (U, J) am Potential derjenigen Referenzspannung (LR, URef) liegt, die dem Multiplexer (M) als Bezugsgröße für die zu messenden Spannungs- und Stromwerte aufgeschaltet ist.

## Claims

1. Measuring arrangement in systems with digital subgroups for the measurement of alternating voltage, alternating current and phase angle by means respectively of a voltage transformer (U) and a current transformer (J), which each at the secondary side (U1 and J1) stand in connection with a multiplexer, characterised thereby, that the output of the multiplexer is connected with an analog-to-digital converter and that a respective pole (U2 and J2) of the secondary sides of each of the voltage transformer (U) and the current transformer (J) lies at the potential of that reference voltage (LR, URef), which is applied to the multiplexer (M) as reference magnitude for the values of voltage and current, which are to be measured.

## Revendications

1. Dispositif de mesure dans des systèmes avec des sous-groupes numériques pour mesurer une tension alternative, un courant alternatif et un angle de phase au moyen de respectivement d'un convertisseur de tension (U) et d'un convertisseur de courant (J), qui sont respectivement en communication du côté secondaire (U1 et J1) avec un multiplexeur, dispositif caractérisé en ce que la sortie du multiplexeur est reliée à un convertisseur analogique-numérique et en ce que respectivement, un pôle (U2 et J2) des côtés secondaires du convertisseur de tension et du convertisseur de courant (U, J) est au potentiel de la tension de référence (Lr, URef), qui est appliquée au multiplexeur (M) en tant que grandeur de référence pour les valeurs de tension et les valeurs de courant à mesurer.

Fig.1

Fig.2